# EUROPEAN PATENT SPECIFICATION

(11) **EP 2 182 688 B1**
(45) Date of publication and mention of the grant of the patent: **31.08.2011**
(21) Application number: 10152189.6
(22) Date of filing: 20.07.2007
(51) Int. Cl.: H04L 25/03, H04B 3/14, H03G 1/00, H03G 3/30

(54) **Equalizer filter with mismatch tolerant detection mechanism for lower and higher frequency gain loops**
Entzerrerfilter mit einem fehlanpassungstoleranten Detektionsmechanismus für Verstärkungsschleifen niedrigerer und höherer Frequenz
Filtre égaliseur à mécanisme de détection tolérant aux défauts d'appariement pour des boucles de gain de fréquences inférieures et supérieures

(43) Date of publication of application: 05.05.2010
(62) Divisional of application: 07784906.5
(73) Proprietor: Eqcologic NV, 1040 Brussel (BE)
(72) Inventor: Maillard, Xavier, B-1673, Beert (BE)
(74) Representative: Bird, William Edward

(56) References cited:
- EP-A1- 1 447 950
- EP-A1- 1 763 188
- US-A1- 2005 127 993
- JONG-SANG CHOI ET AL: "A CMOS 3.5gbps continuous-time adaptive cable equalizer with joint adaptation method of low-frequency gain and high-frequency boosting" 2003 SYMPOSIUM ON VLSI CIRCUITS. DIGEST OF TECHNICAL PAPERS. KYOTO, JAPAN, JUNE 12 - 14, 2003; [SYMPOSIUM ON VLSI CIRCUITS], NEW YORK, NY : IEEE, US, 12 June 2003 (2003-06-12), pages 103-106, XP010651100 ISBN: 978-4-89114-034-2

## Description

### Technical field of the invention

The present invention relates to the field of data communication. More particularly, the present invention relates to devices and corresponding methods for equalizer filtering in a line equalizer system, which restore attenuated signals transmitted over a communication or transmission channel for a wide variety of communication or transmission channels with an acceptable amount of jitter. The present invention also relates to the use of an equaliser in communications system, e.g. in a modem.

### Background of the invention

An equalizer system in general compensates frequency dependent losses that a signal experiences when passing through a transmission channel. Transmission channels include, but are not limited to, a wire, a pair of wires, an optical fibre, the reading and writing channels of a storage device like a hard-disc or optical disc, a wireless connection such as a point-to-point or diffuse infra-red or radio connection. A pair of wires includes a twisted pair, a twinax coax or a differential transmission line on a printed circuit board.

The compensation level of an equalizer system in general can be self-adaptive, fixed or programmable e.g. by a voltage or via a set of switches. A self-adaptive equalizer system continuously estimates the matching compensation level. It typically includes an adaptable filter, a control loop and an output reconstruction unit.

EP-1392001 describes how to organise a control loop in an equalizer system such that self-adaptation is achieved, independently from the transmit amplitude and the transmitted bit pattern. A feed-back control signal is generated from the equalised output of an equalizer filter. Depending on whether the output signal has been under- or over-compensated, the feed-back control signal increases or decreases, such that after a reasonable time the feed-back control signal converges to a value where matched compensation is reached. The control loop is formed by a first means for measuring a short-term-amplitude signal of the output signal, a second means for measuring a long-term-amplitude signal of the output signal and a comparator means for comparing the short-term-amplitude signal and the long-term-amplitude signal, and for determining the evolution of the feed-back control signal.

US-7,180,941 discloses a way to regulate low and high frequency components by comparing low and high frequency components in the signals before and after a slicer digitizer circuit.

EP-1763188and EP1447950 also use low pass and high pass filtering in their low- and high frequency gain regulation systems with increased precision due to a comparator current being adapted in time.

The above documents describe detectors for tuning low and high frequency gain that are using filters based on classical first and/or second order filters. When not using large chip-scale inductors these filters inevitably reduce signal amplitudes. These reduced signal amplitudes are then to be compared making the detection susceptible to mismatches in used comparator circuits.

### Summary of the invention

The teachings of the present invention permits the design of improved equalizer filters and equalizer filtering methods for use in single or multistage equalizer systems which provide restoration of data signals transmitted over a communication channel showing high-frequency attenuation behaviour, high-frequency being defined with respect to the data rate of the transmitted signals. More in particular, structures and methods are provided that allow good detection mechanisms for lower and higher frequency gain loops that are very tolerant for transistor mismatches in the equalizer circuits.

Allowing mismatches in pairs of transistors in an equalizer circuit is important when aiming at high-speed operation.

Further, when aiming at low-voltage equalizers, given transistor mismatch voltages become relatively more important since inevitably one will have to work with smaller internal high-speed data signals. In this case, a higher tolerance to transistor mismatches increases the production yield significantly. Finally, combined high-speed and low-voltage operation is what many equalizers require in present day and future CMOS technologies, thereby operating at voltages smaller than -or equal to- 1.2V and at high speed bit rates, i.e. at 100 Mbps to 100 Gbps.

In a first aspect, the present invention provides an equalizer filter, more particularly an adaptive equalizer filter, for compensating a received distorted or dispersive signal for frequency dependent signal modifications introduced by a transmission channel. The equalizer filter may be a single stage or multistage filter, i.e. it may comprise at least one compensation stage. A compensation stage has at least one gain parameter. Different compensation stages may have different gain parameters, e.g. one compensation stage may be tunable in high frequency while another compensation stage may be tunable in low frequency. The equalizer filter according to embodiments of the first aspect of the present invention as set out in claim 1 may comprise at least one switch, the at least one switch being for changing at least one of the gain parameters in time in function of the compensated signal, there being fewer switches than gain parameters.

An equalizer filter according to embodiments of the present invention may furthermore comprise a control circuit for controlling the actuation of the at least one switch so as to control when the at least one gain parameter is changed.

An equalizer filter according to embodiments of the present invention may furthermore comprise storage means for storing the gain parameters. The storage means may for example be a capacitor, e.g. a parasitic capacitance.

An equalizer filter according to embodiments of the present invention may furthermore comprise a detection circuit for detecting from the compensated signal mismatches in at least one of the gain parameters, and for generating a corresponding mismatch detection signal. The mismatch detection signal may instantaneously indicate a required increase or decrease of at least one of the gain parameters.

In an equalizer filter according to embodiments of the present invention, the at least one switch may be adapted to signal through or link through the mismatch detection signal, more particularly for example to a gain parameter storage means, thus updating the at least one gain parameter with the required increase or decrease. The signalling through may be a combination of multiplexing in time and low pass filtering.

The detection circuit may be a rectifying comparator circuit.

The detection circuit may comprise two differential inputs. Each differential input may comprise two input nodes. The detection circuit may be adapted to compare, from each differential input, signals on those input nodes which are highest in voltage.

The detection circuit may comprise a comparator.

The detection circuit may be adapted for comparing input and output signals of a limiting amplifier.

The detection circuit may furthermore comprise at least one rectifier.

In a second aspect, the present invention provides an equalizer filter, more particularly an adaptive equalizer filter, for compensating a received distorted or dispersive signal for frequency dependent signal modifications introduced by a transmission channel. The equalizer filter according to embodiments of the present invention comprises at least one compensation stage. There are at least two gain parameters for the compensation stages, and each compensation stage has at least one gain parameter. The equalizer filter according to embodiments of the present invention comprises a gain parameter updating circuit for updating the at least two gain parameters, and a detection circuit for detecting, from the compensated signal, mismatches in the gain parameters. The detection circuit may be adapted for generating a mismatch detection signal, the mismatch detection signal being common for the at least two gain parameters.

It is an advantage of some embodiments of the present invention that, due to the detection signal being common for the at least two gain parameters, potential offsets, which may be introduced on the gain parameters e.g. by amplifying signals, are introduced equally for all gain parameters to be changed.

In an equalizer filter according embodiments of the present invention, the mismatch detection signal may instantaneously indicate a required increase or decrease of the gain parameters.

In an equalizer filter according to embodiments of the present invention, the detection circuit may comprise two differential inputs. Each differential input may comprise two input nodes, and the detection circuit may be adapted to compare, from each differential input, signals on those input nodes which are highest in voltage.

In an equalizer filter according to embodiments of the present invention, the detection circuit may furthermore comprise at least one rectifier for rectifying signals on the differential inputs.

The detection circuit may comprise a comparator for comparing signals on the differential inputs.

The detection circuit may be adapted for comparing input and output signals of a limiting amplifier.

An equalizer filter according to embodiments of the present invention may furthermore comprise at least one switch, the at least one switch being for changing at least one of the gain parameters in time in function of the compensated signal. The at least one switch may be adapted to signal through or link through the mismatch detection signal for updating the at least one gain parameter with the required increase or decrease.

In a third aspect, the present invention provides an equalizer system for compensating a received distorted signal for frequency dependent signal modifications introduced by a transmission channel. The equalizer system according to the third aspect comprises an equalizer filter according to any of the embodiments of the equalizer filters of the first or second aspects of the present invention.

In a fourth aspect, the present invention provides a method for using the filter of claim 1 or the system of claim 14 for compensating a distorted signal for frequency dependent signal modifications introduced by a transmission channel, the signal having an amplitude. The method comprises receiving a distorted signal, providing at least two gain parameters and compensating said distorted signal by amplifying the received signal in at least one amplifying compensation stage using the provided gain parameters, and outputting a compensated signal. The method according to embodiments of the present invention furthermore comprises, in function of the amplitude of the compensated signal, changing at least one of the gain parameters multiplexed in time. A plurality of gain parameters may be provided to the at least one at least one compensating stage, and each of the plurality of gain parameters may be changed multiplexed in time, e.g. they may be changed one after the other. In alternative embodiments, at least one of the gain parameters may be changed continuously, depending on the amplitude of the compensated signal, and at least another one of the gain parameters may be changed intermittently, multiplexed in time.

Changing the gain parameters may comprise generating a mismatch detection signal from the compensated signal and multiplexing that mismatch detection signal in time for adapting at least one of the gain parameters. The mismatch detection signal may instantaneously indicate a required increase or decrease of at least one of the gain parameters.

Generating a mismatch detection signal may comprise comparing the compensated signal with an amplified and/or saturated version of the compensated signal.

A method according to embodiments of the present invention may furthermore comprise using the mismatch detection signal for changing at least one of the gain parameters. Changing the gain parameters may comprise multiplexing at least one switch in time, for multiplexed signalling through the mismatch detection signal to at least one of the gain parameters.

A method according to embodiments of the present invention may furthermore comprise storing the at least two gain parameters in a memory element, e.g. a capacitor, such as for example a parasitic capacitance.

In a fifth aspect, the present invention provides a method for compensating a distorted signal for frequency dependent signal modifications introduced by a transmission channel, the signal having an amplitude. The method comprises receiving a distorted signal, providing at least two gain parameters and compensating said distorted signal by amplifying the received signal in at least one amplifying compensation stage using the provided gain parameters, outputting a compensated signal, and detecting from the compensated signal, mismatches in the gain parameters and updating the at least two gain parameters. Detecting mismatches in the gain parameters may be adapted in accordance with embodiments of the present invention for generating a mismatch detection signal common for the at least two gain parameters.

Updating the at least two gain parameters may comprise supplying the common detection signal to each of the at least two gain parameters, and multiplexing it in time for at least one of the gain parameters, i.e. applying or not applying it in time, so as to changing the gain parameters in time in function of the compensated signal. Updating the at least two gain parameters may comprise multiplexing the common detection signal between the at least two gain parameters.

The mismatch detection signal may instantaneously indicate a required increase or decrease of at least one of the gain parameters. Updating the at least two gain parameters may comprise signalling through the mismatch detection signal for updating the gain parameters with the required increase or decrease.

These and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig. 1 shows a schematic representation of an adaptive equalizer with detection and updating mechanism for gain parameters *HFgain* and *LFgain* and having a switch for every parameter, unlike embodiments of the present invention.
Fig. 2 shows the connect signals *connect_LF* and *connect_HF* in response to zero-crossings of a differential input signal *"ln1-ln2"* versus time, the connect signals *connect_LF* and *connect_HF* controlling switches for changing the gain parameters *HFgain* and *LFgain* according to the example of figure 1. ,
Fig. 3 shows an example of an implementation of the connect control block of Fig. 1 for generation of the signals *connect_LF* and *connect_HF.*
Fig. 4 shows an implementation of the rectifying comparator mechanism of Fig. 1 in the form of a rectifying comparator grouped in one circuit featuring also AC-coupling.
Fig. 5 shows signal curves of a simulation of an adaptive equalizer circuit according to figure 1.
Fig. 6 shows a schematic representation of an adaptive equalizer again having a switch for every gain parameter unlike embodiments of the present invention, and having same elements as the adaptive equalizer of Fig.1, however, further including extra amplification means located in the gain updating circuit after the switches.
Fig. 7 shows a schematic representation of another adaptive equalizer regulating *High, Middle,* and Low frequency gain separately.
Fig. 8 shows a schematic representation of connect signals to be generated by the connect control block in the case of the adaptive equalizer schematically illustrated in Fig. 7.
Fig. 9 shows a schematic representation of an adaptive equalizer with detection and updating mechanism for gain parameters *HFgain* and *LFgain* according to an embodiment of the present invention.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

It is to be noticed that the term "comprising", used in the claims, should not be interpreted as being restricted to the means listed thereafter. Thus, the scope of the expression "a device comprising means A and B" should not be limited to devices consisting only of components A and B. It means that with respect to the present invention, the only relevant components of the device are A and B.

Similarly, it is to be noticed that the term "coupled" should not be interpreted as being restricted to direct connections only. Thus, the scope of the expression "a device A coupled to a device B" should not be limited to devices or systems wherein an output of device A is directly connected to an input of device B. It means that there exists a path between an output of A and an input of B which may be a path including other devices or means.

The invention will be described by a detailed description of several embodiments of the invention. It is obvious that other embodiments of the invention can be configured by a person skilled in the art without departing form the technical teaching of the invention, the invention therefore being limited only by the terms of the appended claims. It will be clear for a person skilled in the art that the present invention is also applicable to similar circuits that can be configured in any transistor technology, including for example, but not limited thereto, CMOS, BICMOS and SiGe BICMOS. It will furthermore be clear that similar merits of the invention can be obtained when single-ended signals are implemented as differential signals and vice-versa

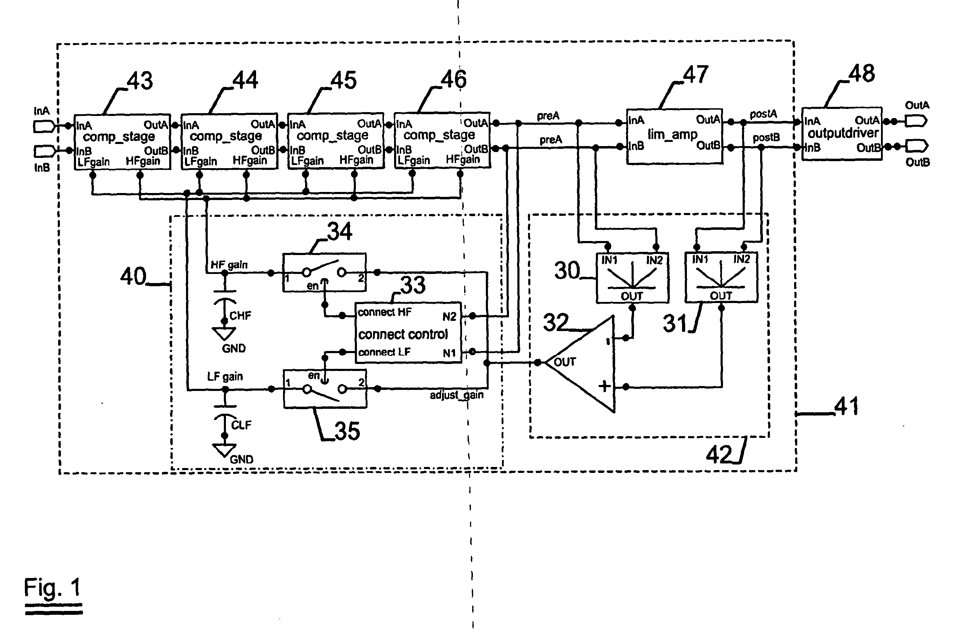

Figure 1 shows a multiple stage example of an adaptive equalizer. The adaptive equalizer may be used in a suitable electronic device, e.g. in a modem or receiver of a telecommunications device.

The adaptive equalizer 41 shows at least one amplifying compensation stage. In Fig. 1, the adaptive equalizer 41 shows a cascade of amplifying compensation stages coupled in series, more particularly a cascade of four compensation stages 43, 44, 45, 46. The number of amplifying compensation stages according to embodiments of the present invention can also be less or more than four. The number of amplifying compensation stages depends on the wanted or required total compensation to be reached, and can differ from application to application. This number also depends on the used circuit integration technology. Therefore, although by way of example an adaptive equalizer 41 is shown having four amplifying compensation stages 43, 44, 45, 46, the invention is not limited thereto.

The signal to be recovered enters at the input of the first amplifying compensation stage 43, at the input node comprising input terminals *inA, inB.* Typically, a signal is supplied to the input node of the equalizer 41 that has more or less suffered from frequency attenuation from a transmission channel with limited bandwidth characteristics, whereby higher frequencies are more attenuated than lower frequencies. The input signal is input in the equalizer 41 at the input node, which serves as the differential input node of the amplifying compensation stage 43. Amplifying compensation stages 43, 44, 45, 46 are used to make an "as good as possible" digital data stream at the output node of the last amplifying compensation stage 46, also the entrance of the limiting amplifier 47, by analog inverse filtering. The amplifying compensation stages 43, 44, 45, 46 can be any type of suitable compensation stages, e.g. compensation stages with a fixed higher frequency gain compensation, programmable compensation stages, tunable compensation stages. Examples of amplifying compensation stages, and how they are driven can be found in literature by the person skilled in the art, including in WO 2004/73274, EP-1622285, EP-1763188. Such stages can be tuned sequentially, or in parallel. For some applications and depending on the bit rate of the envisaged equalizer it can also be sufficient to work with a single stage.

After having travelled through the compensation stages 43, 44, 45, 46, the signal arrives at the limiting amplifier 47 for amplifying and/or digitizing the output of the last amplifying compensation stage 46. This limiting amplifier 47 may itself have a fixed maximum output amplitude.

After the limiting amplifier 47, an output circuit 48 is provided. Output circuit 48 has an output node comprising differential output terminals outA, outB, and can include any useful stage following an equalizing filter in an equalizer system, including but not limited to a bit-slicer, a limiting amplifier, a DC-restoring system or a Schmitt-trigger, and possibly an output driver stage, all known by a person skilled in the art. The output circuit 48 together with the equalizer 41 are part of an equalizer system. This output circuit 48 may be provided to compensate amplitude variations obtained by equalizing, at the expense of very little or no additional jitter.

To obtain an equalizer 41 that is robust to transmit amplitude variations, the amplifying compensation stages 43, 44, 45, 46 preferably each have at least one gain parameter that tunes the low frequency gain, and another gain parameter that tunes the high frequency gain. In Fig. 1, these gain parameter values are stored as a voltage on the nodes *HFgain* for the high frequency gain level, and on node *LFgain,* for the low frequency gain level. It is assumed hereby that a higher stored voltage corresponds to a higher gain value, in both cases. Typical gain ranges for commercial equalizers are from -5dB to +10dB for the low frequency gain range, and -5dB to +35dB for the high frequency gain range. At the output of the last amplifying compensation stage 46 in the cascade, the signal is in its differential form between nodes *preA* and *preB.*

This signal enters the limiting amplifier 47 where it is amplified by a predefined amplification factor over the full useful frequency band, e.g. by 4 to 6 dB. The limiting amplifier 47 has a limited capability of amplification: there is a limitation to the output amplitude, e.g. to 250mV for a 1V technology, or to 700mV for a 3.3V chip technology. This limiting amplifier 47 can be a current mode logic stage (CML-stage) whereby this limitation of the output amplitude gives a digitizing behaviour when the input waveform itself had already a large enough amplitude. Due to its limited output amplitude, possible overshoots present at the input of the limiting amplifier 47 will be clipped in the output signal when these overshoots would be too large to be accommodated by the limiting amplifier 47. It is advised to use a single stage limiting amplifier 47 for good operation of embodiments of the present invention, although the present invention is not limited thereto. The output signal of the limiting amplifier 47 is present between the nodes *postA* and *postB.* This signal may be further amplified, and brought to a node with lower impedance than any previous node in the signal path, in order to form the digital output of the equalizer 41. The bringing to a node with lower impedance may be done to match the impedance of attached transmission lines. An output driver may typically be needed in the output circuit 48 for driving low impedance transmission lines.

The at least one gain parameter is changed, in accordance with embodiments of the present invention, in function of the compensated signal at the output nodes preA, preB of the last compensation stage 46 and optionally in function of the signal at the output nodes postA, postB of the limiting amplifier stage 47. If the compensated signal amplitude is too high, the gain parameters will be lowered, and if the compensated signal amplitude is too low, the gain parameters will be raised correspondingly.

In order to determine the change of the gain parameters, a detection mechanism 42 for determining the required high frequency gain and low frequency gain is provided in accordance with embodiments of the present invention. The detection mechanism 42 may be a rectifying comparator mechanism. In Fig. 1, the signals on the input nodes *preA, preB* of the limiting amplifier 47 are rectified in a first rectifier 30. The signals on the output nodes *postA, postB* of the limiting amplifier 47 are rectified by a second rectifier 31. The output signals of the first and second rectifiers 30, 31 are compared by a comparator 32. It is advantageous if the comparator 32 and its preceding first and second rectifiers 30, 31 have a sufficiently high bandwidth, comparable to the maximum bit-rate. For example, a 10-Gbps equalizer 41 would preferably have 10-GHz fast rectifiers 30, 31 and comparator 32. In that way, the voltage on the output node *adjust_gain* of the comparator 32, will always and instantaneously tell whether the absolute value of the signal at the input of the limiting amplifier 47 is smaller or larger than the absolute value at the output of the equalizer 41. When the voltage on the output node *adjust_gain* of the comparator 32 is HIGH, this indicates that the absolute value of the signal at the input of the limiting amplifier 47 is too low and should be higher in order to match the absolute value of the signal at the output of the limiting amplifier 47. When the voltage on the output node *adjust_gain* of the comparator 32 is LOW, this indicates that the absolute value of the signal at the input of the limiting amplifier 47 is too high and should be lower in order to match the absolute value of the signal at the output of the limiting amplifier 47. The gain parameters of the compensation stages 43, 44, 45, 46 may be controlled to be adapted accordingly.

The control of the gain parameters is performed in updating mechanism 40 as follows. During a pre-determined period after a zero-crossing of the data, e.g. on the node preA, preB, the signal on the output node *adjust_gain* of the detection circuit 42, in Fig. 1 the output of comparator 32, is indicative for whether there is too much or too little high frequency gain. Just before a zero-crossing the signal on the output node *adjust_gain* of the detection circuit 42, in Fig. 1 the output of comparator 32, is indicative for whether there is too much or too little low frequency gain. Now, in order to adapt the voltages on the *HFgain* and *LFgain* nodes to this fact, the updating circuit 40 comprises a connect control block 33, to control the enable of first and second switches 34, 35 to link through the signal on the output node *adjust_gain* of the comparator 32 to the *HFgain* node and *LFgain* node, respectively, at the appropriate moments in time, and to update the HFgain and LFgain voltages (gain parameters) in the right direction (up or down). This way, the signal on the output node *adjust_gain* of the detection circuit 42, e.g. at the output node of comparator 32, is time multiplexed in order to separately control the high frequency gain parameter (HFgain) and the low frequency gain parameter (LFgain).

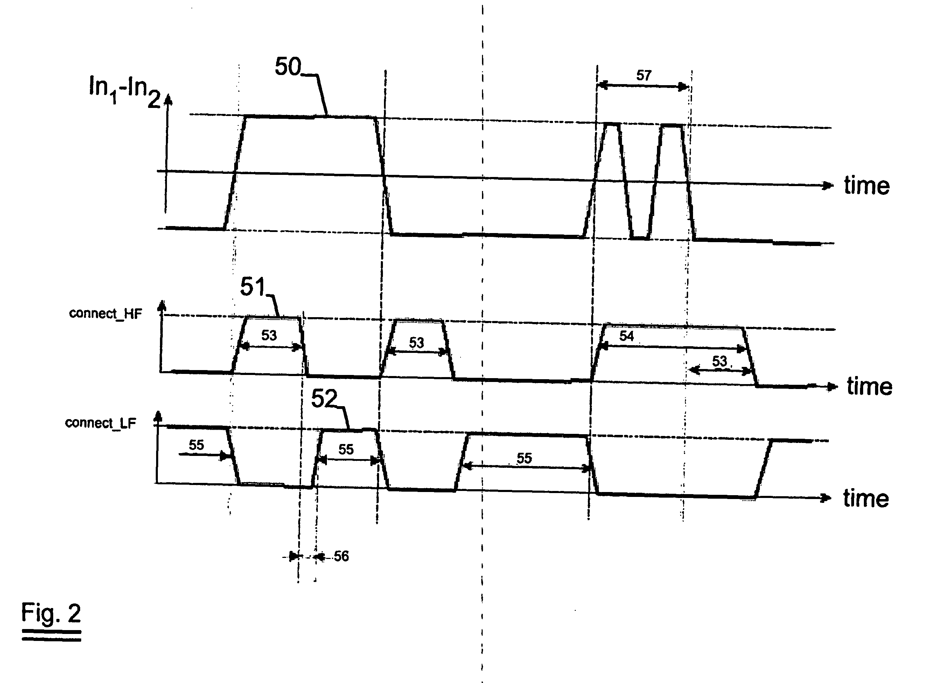

The connect control block 33 generates the enable signals *connect_HF* and *connect_LF* for first and second switches 34, 35, based on the values of the compensated signal at the output nodes preA, preB of the last compensation stage 46,. This is illustrated in Fig.2. In between two zero-crossings of a data signal at the output nodes of the amplifying compensation stages, the time domain is split into different parts, each part being for updating a particular gain parameter. One implementation of a method for controlling adaptation of the gain parameter values on the *HFgain* and *LFgain* nodes is to choose a fixed period for keeping the first switch 34 (for controlling the high frequency gain parameter value) conductive after a zero-crossing of the data signal 50 at the output of the compensation stages, in particular at the output of the last compensation stage 46. This period is called the *"just crossed period"* 53. This *just-crossed period* 53 can be for example for a period of 1 bit. At 1-Gbps this *just-crossed period* 53 then corresponds to 1-ns. During the *just-crossed period* 53, the *connect_HF* signal 51 is HIGH. The remainder of the time until the next zero crossing can then be used for making the second switch 35 (for controlling the low frequency gain parameter value) conductive by making *connect_LF* 52 HIGH in the periods indicated by 55, i.e. periods between a *just-crossed period* 53 and a next zero crossing. In alternative embodiments, the *just-crossed period 53* can also be taken longer than 1 bit, but one has to make sure that enough often the complimentary second switch 35 will be conductive, in order to keep the low-frequency gain parameter value, i.e. the voltage on the *LFgain* node, updated. With *just-crossed periods* longer than one bit, the first switch 34 can be driven to the conductive state during several bits on a row, as indicated by reference number 54 in Fig. 2, when having alternating HIGH and LOW data bits 57. This natural extension of the *just-crossed period* 53 doesn't hinder the good operation of the equalizer 41. A good practice is to make the *connect_LF* signal 52 HIGH at moments when the *connect_HF* signal 53 is LOW. However, it is also possible to wait a little time 56 after a falling edge of the *connect_HF* signal 51, before making the *connect_LF* signal 52 HIGH e.g. a time with a fixed duration of the order of 1 bit or less, for example a time between one third of a bit and one bit, or thus for the 1-Gbps example given above between 1/3 ns and 1 ns. The falling edge of the *connect_LF* signal and the rising edge of the *connect_HF* signal should be aligned close to a zero-crossing in the signal 50 at the output of the amplifying compensation stages for achieving reliable tuning of the gain parameters, e.g. LFgain and HFgain loops, e.g. by taking the latency of the detection mechanism 42, e.g. rectifying comparator circuit, into account..

The *HFgain* and *LFgain* nodes are preferably capacitively coupled to the ground, by means of a (parasitic) capacitor *CHF* and *CLF,* respectively, to average out the impulses given to them through the first and second switches 34, 35. In that way, they become the dominant pole in the *HFgain* and *LFgain* tuning loops. The first and second switches 34, 35 may have a large resistive value in their conductive state (e.g. by using minimal area transistors), such that finding the optimal *HFgain* and *LFgain* values gets averaged out over more than 1 edge, e.g. 10 to 10000 edges. The lower this number of edges, the quicker the self adaptive equalizer 41 will converge to its final destination, however the more it can become dependent on single-event signal errors. Since in most applications, the start-up speed is not an issue, it is advised to rely on a larger set of edges, in other words, to average out over a longer period.

An alternative to the proposed system, as shown hereinabove, is to work with small currents that drive the voltages on the capacitors *CHF* and *CLF* upwards and/or downwards. The driving currents then have a duration determined by the duration of the *just-crossed period* 53, and have an amplitude dependent on the amplitude of the compensated signal at the output nodes preA, preB of the amplifying compensation stages.

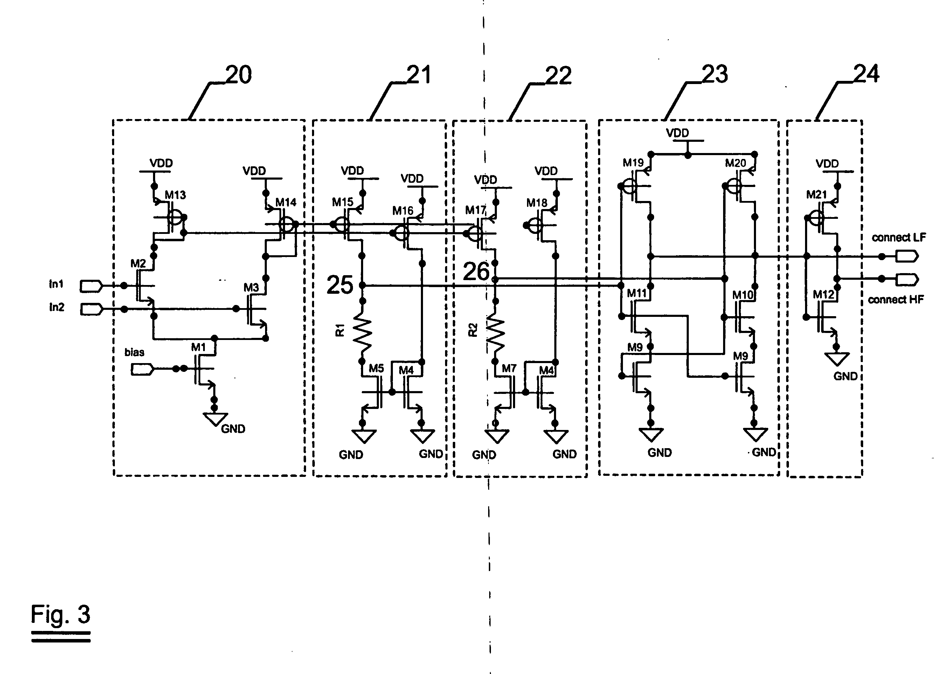

Figure 3 shows an example of an implementation of the connect block 33 of the updating circuit 40 for generating the connection signals *connect_LF* and *connect_HF.* Transistors M1, M2, M3, M13 and M14 can be considered as an input stage 20, amplifiying the differential signal at its inputs IN1, IN2 (which corresponds to the signal at the output nodes *preA* and *preB* at the output of the compensation stages). Transistors M4, M5, M15, M16 and resistor R1 form a first output stage 21 that goes to HIGH on node 25 during a certain input polarity of the input signal. Transistors M6, M7, M17, M18 and resistor R2 form a second output stage 22 that goes to HIGH on node 26 during the opposite input polarity of the input signal. The outputs of these first and second output stages, the signals one nodes 25 and 26, have short rise times, and long fall times. These fall times are long due to the use of resistors R1 and R2. Transistors M8...M11, M19 &M20 form a symmetric NAND port 23 with respect to the output *connect_LF* and an AND port when referred to output *connect_HF* by use of an inverter 24. Just before zero crossing, one of the signals on 25 and 26 is digitally HIGH, and one is digitally LOW. Just after the zero crossing, they will both be digitally HIGH, since the rise time was designed to be short. This is the start of the *"just crossed period'* 53. One of the signals on nodes 25 or 26 will then decrease relatively slowly due to the resistor in the discharge path, the transistor gates of the NAND port 23, acting as load capacitance. Unless another zero-crossing happens, the signal will drop enough digitally LOW to make the NAND gate switch its output. The *"just crossed period"* 53 is then over and period 55 starts. This *"just-crossed period"* 53 can take the duration of several bits, depending on the resistor values of resistors R1 and R2, and their capacitive loads (gates of the NAND port 23). During the *just-crossed period* 53, the *connect_HF* signal will be digitally HIGH, thereafter, it will be digitally LOW. *Connect_LF* is the opposite of this signal in this embodiment. Using opposite signals for *Connect_LF* and *Connect_HF* works fine for most applications. One can however choose to let the *connect_LF* to go digitally HIGH, somewhat later than the *connect_HF* went digitally LOW as aforementioned. This mainly speeds up convergence, but precision of convergence is not affected very much.

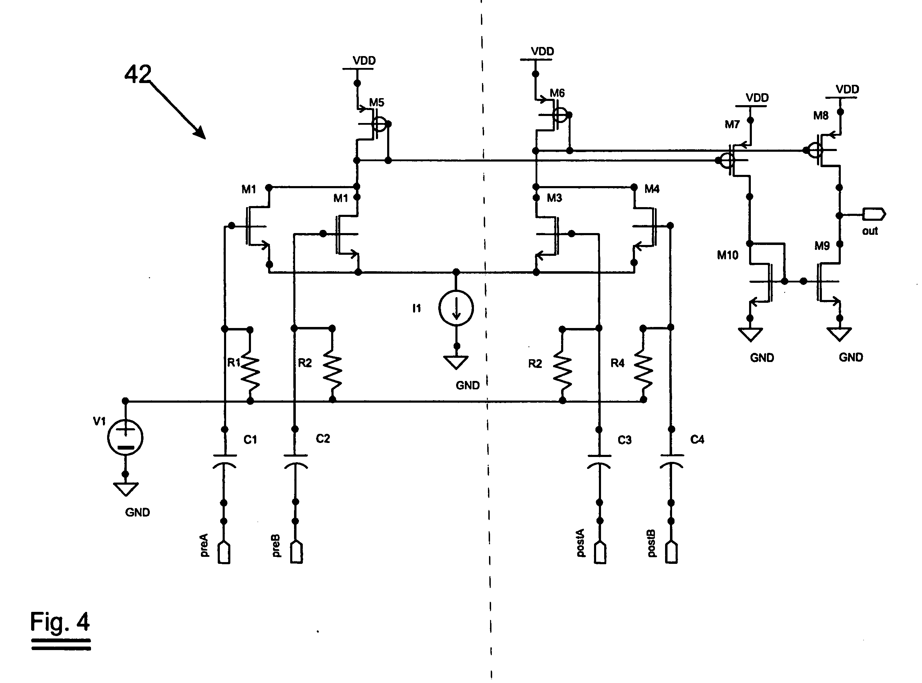

Figure 4 illustrates a rectifying comparator circuit 42, in which the rectifiers and the comparator are provided in a combined way. It also shows how the comparison can be obtained in a way such that the common mode of the signals won't spoil the effective comparison. The signals on the nodes *preA, preB* and *postA, postB,* i.e. on the nodes before and after the limiting amplifier 47 are input to the rectifying comparator circuit 42. Capacitors *C1...C4* and resistors *R1...R4* form an AC-coupling system. The capacitors C1, C2, C3, C4 are bypassing the input signals with essentially their full swing, and the resistors *R1, R2, R3, R4* bias the average voltages to the voltage present on *voltage source V1.* In other words, the differential voltages originating from different places in the circuit (before and after the limiting amplifier 47) are levelled to a voltage level *V1.* This voltage *V1* is chosen to be in the common mode input range of the subsequent rectifying comparator. *preA* and *preB* are the signals that are also the input voltages to the limiting amplifier. *postA* and *postB* are the signals at the output of the limiting amplifier. The gates of transistors M1 and M2 are driven by the level shifted *preA* and *preB* signals. Whichever signal on the nodes preA, preB has highest voltage, its connected transistor M1, M2 will go into comparison, with the signal on any of the transistors M3 and M4. The gates of transistors M3 and M4 are driven by the level shifted *postA* and *postB* signals. Whichever of these signals has highest voltage, its connected transistor will go into comparison, with the signal on any of the transistors M1 and M2. In this way, the highest signal of *preA* and *preB* will be compared to the highest signal of *postA* and *postB.* When it is assumed that there is no time dependent common mode component on either of the signals, one can prove that one actually performs an action that is similar to comparing the absolute value of the input of the limiting amplifier with the absolute value of the output of the limiting amplifier. This is also similar to first rectifying and then comparing the input signal with the output signal of the limiting amplifier.

Other detection circuits 42 providing similar merits can also be designed by a person skilled in the art, without departing from the scope of the invention as defined by the appended claims. However, the combination of comparing the highest of the signals in a double differential stage as in Fig. 4 is advised to be used. Mirroring through transistors M5...M8 and generating an output signal that can span the full output voltage range is known by the person skilled in the art. Also other output structures than this can be used. The output out of the detection circuit 42, e.g. rectifying comparator circuit, delivers a comparison signal for use on node *adjust_gain* for controlling the adaptation of the gain in function of the compensated signal at the output of the amplifying compensation stages.

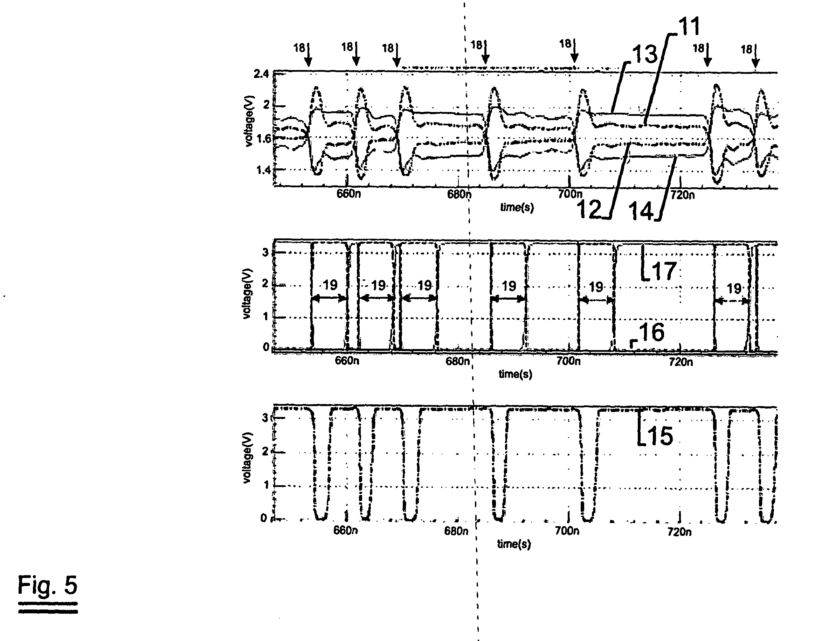

Figure 5 shows curves illustrating the operation of the adaptive equalizer 41. Curves 11, 12 are signals at nodes *preA, preB* at the input of the limiting amplifier 47. Signals 13, 14 are signals at nodes *postA, postB* at the output of the limiting amplifier 47. Just after each transition 18 (i.e. after a zero crossing 18), the curves 11 & 12 show overshoots with respect to curves 13 & 14. In other words, the amount of HF-gain has to be decreased. Some time later, and until the next zero crossing, the amplitude between signals 11 and 12 is smaller than between signals 13 and 14. So the low frequency gain LFgain has to increase. Signal 15 is the signal at node *adjust_gain,* being the output of the detection circuit 42, e.g. rectifying comparator circuit. Just after each zero-crossing, this signal goes digitally LOW, indicating that the high frequency gain *HFgain* should be decreased. Somewhat later, it goes digitally HIGH indicating that the low frequency gain *LFgain* must be increased.

Curve 16 is the *connect_HF* signal that shows when the switch 34 towards the *HFgain* node has to become conductive. Curve 17 is the *connect_LF* signal that shows when the switch 35 towards the *LFgain* node has to become conductive. As it is shown, the "*just crossed period 19*" is not precisely matching the periods when signal 15 on the node *adjust_gain* is digitally LOW. This shows that there is some crosstalk between the two error detectors for the high frequency gain and the low frequency gain. In this case, the high frequency gain *HFgain* updating is not only determined by the high frequency gain *HFgain* being too LOW, but also by the low frequency gain *LFgain* being too HIGH. This is not a problem, since after some time the low frequency gain error will go to zero, and by then, the high frequency gain detector will be depending solely on the its own high frequency gain error. The exact *"just crossed period"* length 19 is thus not so critical. It is suggested to be taken between 0.3 and 3 bits period, in particular cases between 0.5 and 1 bits period.

In general, this way of operating the detection for low frequency gain *LFgain* and high frequency gain *HFgain* updating is very robust with respect to mismatches in transistor pairs. This is due to the fact that the gain adjustment signals are split into error signals for high frequency gain and low frequency gain updating only late in the procedure: in the embodiments illustrated, signals are first rectified and amplified in the rectifying comparator circuit 42, before splitting them into error signals for the high frequency gain *HFgain* and low frequency gain *LFgain* updating. At the place the signals are split (at the first and second switches 34, 35) the signals are very large with respect to possible transistor offsets due to this prior amplification. Before the switches 34, 35, a mismatch, e.g. in the comparator 32, is not harming the balance between the low frequency gain *LFgain* and the high frequency gain *HFgain:* such mismatch will only result in a different amplitude of the EYE diagram before and after the limiting amplifier 47: both low frequency *LFgain* and high frequency gain *HFgain* will be tuned to a too HIGH or a too LOW value (depending on the sign of the offset mismatch), but low frequency gain *LFgain* and high frequency gain *HFgain* will be still in balance which each other.

An option is to make the *"Just crossed period"* length 19 dependable on the features in the high-speed data signal e.g. *"preA-preB"* at the level of the input of the limiting amplifier 47. One can for example choose to make the period length 19 adapt to the shortest measured HIGH or LOW periods in this data signal. In that way a good-equalizing precision can be obtained over a large frequency (or bit-) range of operation. Another option is to make the *"just crossed period"* length 19 dependable on internal signal values, including on *HFgain, LFgain* or bitrate. In the latter case, a sensor may be provided that measures the bit rate. Commercial broadband equalizers require that at lower bit rate also longer cable lengths can be equalized. One can thus anticipate that, when having high compensation levels (= a relative high high-frequency gain *HFgain* voltage), longer transmission cable is attached to the input of the equalizer 41, and that a lower bit rate is to be handled. The *"Just crossed period" length* 19 can then be increased accordingly.

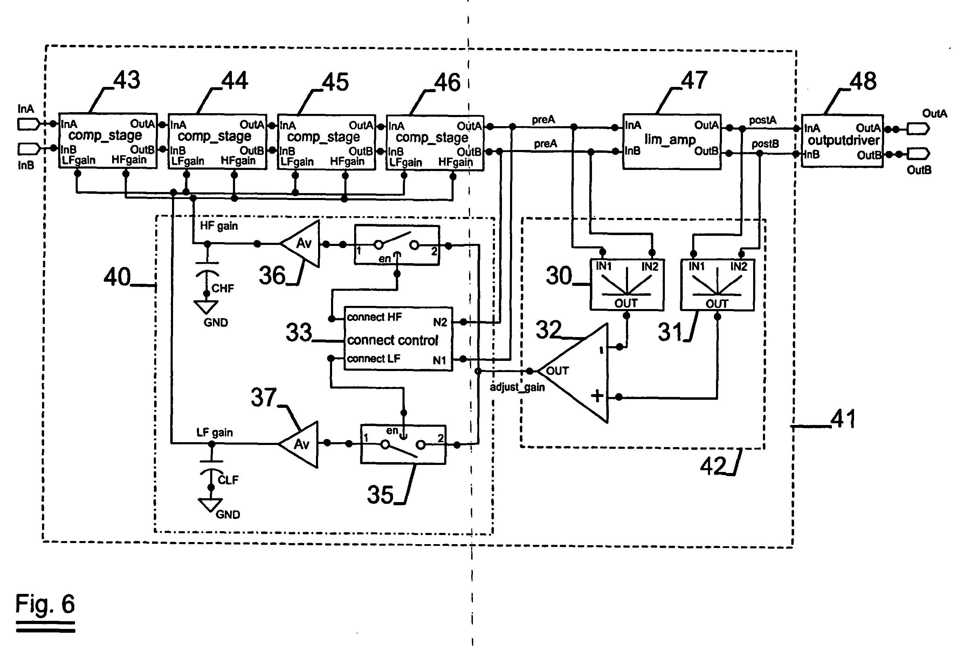

At high speed, with respect to the used chip-technology, the detection circuit 42, e.g. the rectifying comparator like in Fig. 4, may not be able to generate enough gain to cover the whole range of voltages required by nodes *LFgain* and *HFgain.* In that case the gain of the detection circuit 42, e.g. the comparator gain of comparator 32, can be kept to a moderate value, e.g to a factor of 2-5, then the switching can be performed, and then more gain can be applied (another factor of e.g.10-100), as is being illustrated in Fig. 6. In the embodiment illustrated in Fig. 6 first and second updating amplifiers 36, 37 are shown to demonstrate a good position of the extra gain stages 36, 37. The position of the updating amplifiers 36, 37 as illustrated in Fig. 6 is particularly good, as in this embodiment the amplifiers 36, 37 may be slow amplifiers, which is not the case if the amplifiers 36, 37 are located before the split (node *adjust_gain).* Furthermore, a position of the amplifiers 36, 37 after the capacitors CHF, CLF is not good for noise issues.

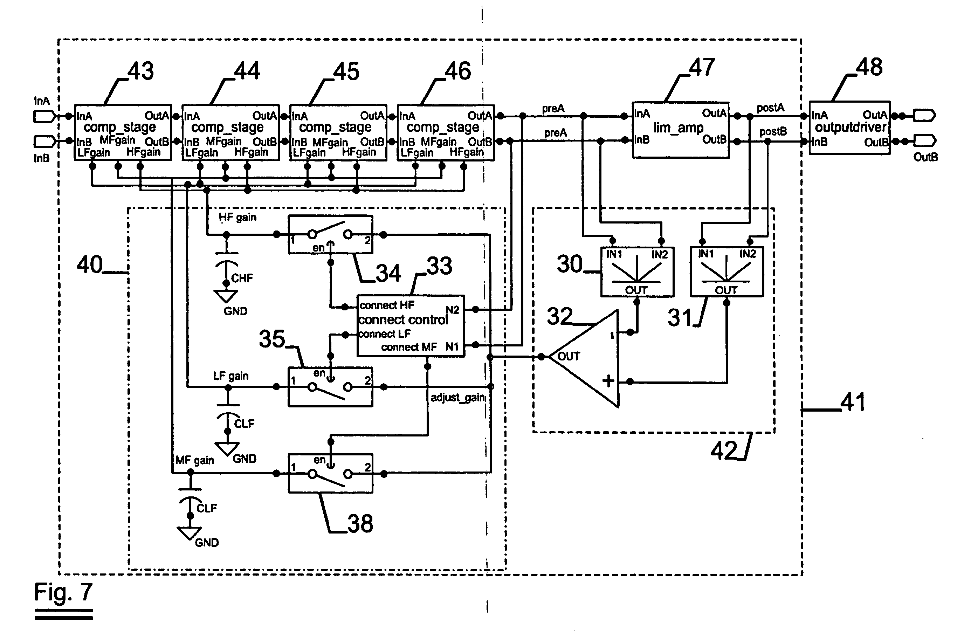

Figure 7 shows an extension of the basic principle of the present invention to a third tuning parameter, the *MFgain* (middle frequency gain). Extensions to more tuning parameters are possible as well, although not explained in detail in the present document. The updating circuit 40 comprises a connect control block 33, and three switches 34, 35, 38. The switches 34, 35, 38 are for linking through gain updating signals on the output node *adjust_gain* of the detection circuit 42 to the respective gain nodes *HFgain, LFgain, MFgain* at appropriate moments in time under control of the connect control block 33. The connect control block 33 as in the embodiment explained with regard to Fig. 1 and Fig. 6, generates a first signal *connect_HF* that is digitally HIGH just after a cross-over period and a second signal *connect_LF* that is digitally HIGH before a cross-over period. The connect control block 33 now also generates a third signal *connect_MF,* that is digitally HIGH in between the period that *connect_HF* and *connect_LF* are digitally HIGH. A zero crossing still terminates the being HIGH of *connect_LF,* and still starts the going HIGH of *connect_HF.* In this way, a larger set of different types of cables can be compensated, since the matching of the amplification curve with the cable attenuation curve can be achieved at different frequencies, corresponding to different moments in time. Further this can also serve the operation over an extended operational bit frequency in the data signal.

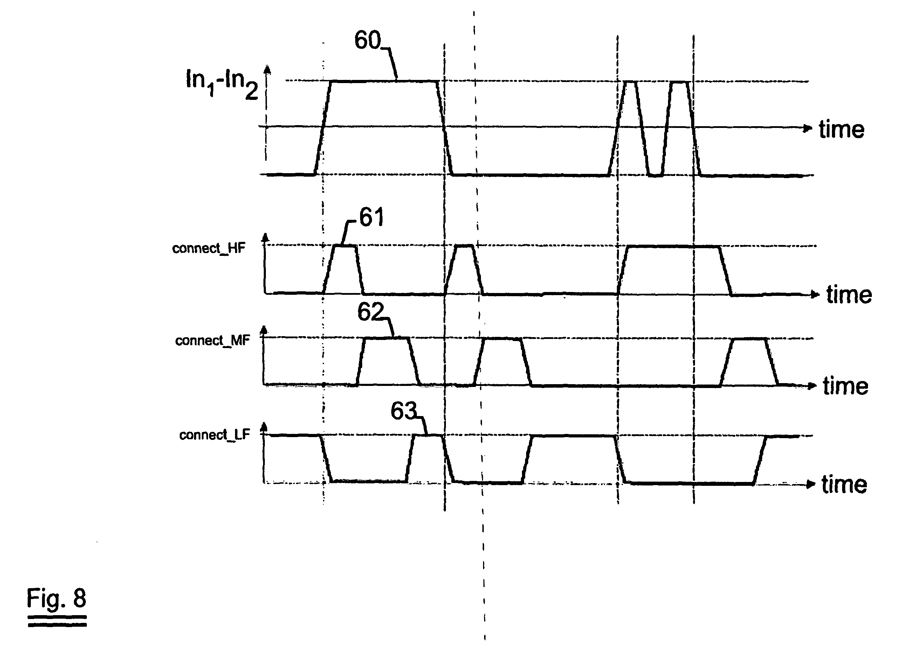

Figure 8 illustrates the positioning of the *connect_MF* in the middle between *connect_HF* and *connect_LF,* i.e. the middle frequency gain is adjusted after the high frequency gain has been adjusted and before the low frequency gain is adjusted. Just after a zero crossing of the data signal 60 at the output of the compensation stages, in particular at the output of the last compensation stage 46, *connect_HF* 61 goes digitally HIGH, for a first period, e.g. a first fixed period, followed by *connect_MF* 62 going digitally HIGH for a second period, e.g. a second fixed period, followed by *connect_LF* 63 going digitally HIGH until the next zero-crossing of the data signal 60. When a zero-crossing in data signal 60 occurs in the middle of the period when *connect_MF* 62 is digitally HIGH, *connect_MF* 62 should go digitally LOW as soon as possible, and in that case *connect_LF* will not go digitally HIGH until the next opportunity to do so, i.e. until after the next time *connect_MF* has gone digitally HIGH and digitally LOW again. When a zero-crossing in data signal 60 occurs in the middle of the period when *connect_LF* 63 is digitally HIGH, *connect_LF* 63 should go digitally LOW as soon as possible. A person skilled in the art can design a control circuit 33 that accordingly generates these sampling signals *connect_HF* 61, *connect_MF* 62 and *connect_LF* 63 in function of the compensate data signal 60 on the output nodes *preA, preB* of the amplifying compensation stages.

Analogously to what is explained with respect to Fig. 2, *connect_MF* can go digitally HIGH as soon as *connect_HF* is digitally LOW, and *connect_LF* can go digitally HIGH as soon *as connect_MF* is digitally LOW. Alternatively, it is possible to wait a little time, e.g. in the order of one third to 1 bit, after a falling edge of *connect_HF,* respectively *connect_MF* before making *connect_MF,* respectively *connect_LF* digitally HIGH. It is particularly advantageous to align the falling edge of *connect_LF* and the rising edge of *connect_HF* close to the zero-crossing in data signal 60 for achieving reliable tuning of the gain loops.

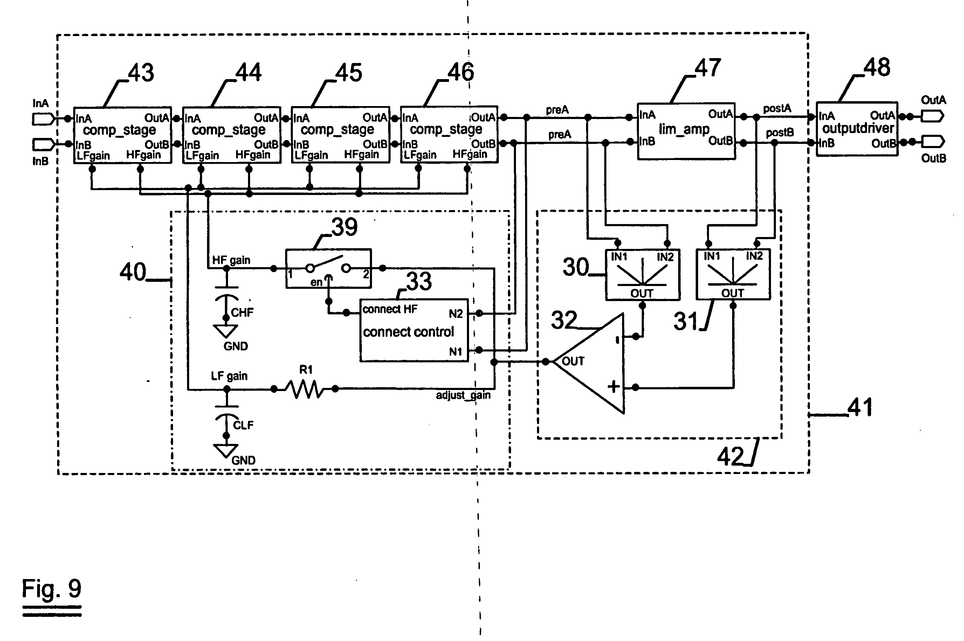

For some less demanding applications, it can be sufficient to provide a limited number of switches in the updating mechanism 40, the limited number of switches being less than the number of gain parameters used in the compensation stages. As an example only, an equalizer 41 according to an embodiment of the invention is illustrated in Fig. 9, having a cascade of four amplifying compensation stages 43, 44, 45, 46, each of the amplifying compensation stages having at least one gain parameter, for example, as illustrated in Fig. 9, one gain parameter *LFgain* that tunes the low frequency gain, and another gain parameter *HFgain* that tunes the high frequency gain. The at least one gain parameter is changed, in accordance with embodiments of the present invention, in function of the compensated signal at the output nodes *preA, preB* of the last compensation stage 46. If this compensated signal is too high, the gain parameters will be lowered, and if the compensated signal is too low, the gain parameters will be raised correspondingly. In order to determine the change of the gain parameters, a detection mechanism 42 for determining the required high frequency gain and low frequency gain is provided, as also explained with regard to other embodiments described. The control of the gain parameters is performed in updating mechanism 40 as explained hereinafter.

In the update mechanism 40 a limited number of switches, the number being smaller than the number of gain parameters used in the amplifying compensation stage, e.g. only one switch 39, may be present, as for example illustrated in Fig. 9, where the switch 39 is provided at the updating side for the *HFgain* parameter. The *LFgain* parameter is then updated by the full average of the *adjust_gain* signal, including the error signal used for the *HFgain* updating. During a pre-determined period after a zero-crossing of the data, e.g. on the node *preA, preB,* the signal on the output node *adjust_gain* of the detection circuit 42, in the embodiment illustrated in Fig.9 the output of comparator 32, is indicative for whether there is too much or too little high frequency gain. The updating circuit 40 comprises a connect control block 33, to control the enable of switch 39 to link through the signal on the output node *adjust_gain* of the comparator 32 to the *HFgain* node. At the same time, the singal on the output node *adjust_gain* of the comparator 32 is also linked through to the *LFgain* node. The *HFgain* voltage (gain parameter) is adapted in the right direction (up or down, depending on the signal *adjust_gain*), and the *LFgain* voltage (gain parameter) is adapted in the same direction. By the time, however, that the *HFgain* gets at its correct value, switch 39 will be controlled by connect control block 33 to switch off, an the signal *adjust_gain* will then solely serve to bring the *LFgain* at its best position as well. It is, however, advised to use a system whereby the plurality of gain parameters, are each getting updated through switches.

It is to be understood that although preferred embodiments, specific constructions and configurations, as well as materials, have been discussed herein for devices according to the present invention, various changes or modifications in form and detail may be made without departing from the scope of this invention.

## Claims

1. An equalizer filter (41) for compensating a received distorted data signal for frequency dependent signal modifications introduced by a transmission channel, said equalizer filter (41) comprising at least one compensation stage (43, 44, 45, 46), a compensation stage (Xstage1, Xstage2, Xstage3, Xstage4) having two or more gain parameter inputs (HFgain, LFgain), the equalizer filter (41) comprising one or more switches (39), each being for coupling a gain feedback signal (adjust_gain) for changing a different one of the gain parameter inputs (HFgain) in time in function of the compensated signal, the equalizer filter being **characterised in that** it further comprises a connect control circuit (33) for outputting a signal (*connect_HF*) for controlling each of the switches to couple the gain feedback signal for a different part of a time interval between zero-crossings of the compensated signal, and there being fewer switches than gain parameters, so the gain feedback signal (adjust_ gain) is coupled without a switch to update at least one (LFgain) of the gain parameters.

2. An equalizer filter (41) according to claim 1, the control circuit (33) for controlling the actuation of the switch so as to control when a high frequency gain parameter (HFgain) is changed.

3. An equalizer filter (41) according to any of the previous claims, furthermore comprising storage means for storing the high frequency and a low frequency gain parameter (HFgain, Lfgain).

4. An equalizer filter (41) according to any of the previous claims, furthermore comprising a detection circuit (42) for detecting from the compensated signal mismatches in the high frequency gain parameter and in a low frequency gain parameter (HFgain, LFgain), and for generating a corresponding mismatch detection signal.

5. An equalizer filter (41) according to claim 4, wherein the mismatch detection signal instantaneously indicates a required increase or decrease of the gain parameters (HFgain, LFgain).

6. An equalizer filter (41) according to any of claims 4 or 5, wherein the switch (34, 35; 38; 39) is adapted to signal through the mismatch detection signal, thus updating the high frequency gain parameter (HFgain) with the required increase or decrease.

7. An equalizer filter (41) according to any of claims 4 to 6, wherein the detection circuit (42) is a rectifying comparator circuit.

8. An equalizer filter (41) according to any of claims 4 to 7, wherein the detection circuit (42) comprises two differential inputs (*preA, preB; postA, postB*).

9. An equalizer filter (41) according to claim 8, each differential input comprising two input nodes, wherein the detection circuit (42) is adapted to compare, from each differential input, signals on those input nodes which are highest in voltage.

10. An equalizer filter (41) according to any of claims 4 to 9, wherein the detection circuit (42) comprises a comparator (32).

11. An equalizer filter (41) according to any of claims 4 to 10, wherein the detection circuit (42) is adapted for comparing input and output signals of a limiting amplifier (47).

12. An equalizer filter (41) according to any of claims 4 to 11, wherein the detection circuit (42) furthermore comprises at least one rectifier (30, 31).

13. An equalizer filter (41) according to any of claims 4 to 12, the switch being for changing the high frequency gain parameter (HFgain) in time in function of the compensated signal at output nodes of the at least one compensation stage.

14. An equalizer system for compensating a received distorted signal for frequency dependent signal modifications introduced by a transmission channel, said equalizer system comprising an equalizer filter (41) according to any of claims 1 to 13.

## Patentansprüche

1. Entzerrerfilter (41) zum Kompensieren eines empfangenen verzerrten Datensignals für frequenzabhängige Signalmodifizierungen, die durch einen Übertragungskanal eingeführt werden, wobei das Entzerrerfilter (41) mindestens eine Kompensationsstufe (43, 44, 45, 46) umfasst, wobei eine Kompensationsstufe (Xstage1, Xstage2, Xstage3, Xstage4) zwei oder mehr Verstärkungsparametereingänge (HFgain, LFgain) aufweist, wobei das Entzerrerfilter (41) ein oder mehrere Schalter (39) umfasst, die jeweils zum Koppeln eines Verstärkungsrückkopplungssignals (adjust_gain) dienen, um einen anderen der Verstärkungsparametereingänge (HFgain) zeitgerecht abhängig vom kompensierten Signal zu ändern, wobei das Entzerrerfilter **dadurch gekennzeichnet ist, dass** es des Weiteren eine Verbindungssteuerschaltung (33) zum Ausgeben eines Signals (connect__HF) zum Steuern jedes der Schalter umfasst, um das Verstärkungsrückkopplungssignal für einen anderen Teil eines Zeitintervalls zwischen Nulldurchgängen des kompensierten Signals zu koppeln, wobei weniger Schalter als Verstärkungsparameter vorhanden sind, so dass das Verstärkungsrückkopplungssignal (adjust_gain) ohne Schalter zur Aktualisierung mindestens eines (LFgain) der Verstärkungsparameter gekoppelt ist.

2. Entzerrerfilter (41) nach Anspruch 1, wobei die Steuerschaltung (33) zur Steuerung der Betätigung des Schalters dient um zu steuern, wann ein Hochfrequenz-Verstärkungsparameter (HFgain) geändert wird.

3. Entzerrerfilter (41) nach einem der vorangehenden Ansprüche, des Weiteren umfassend ein Speichermittel zum Speichern des Hochfrequenz- und eines Niederfrequenz-Verstärkungsparameters (HFgain, LFgain).

4. Entzerrerfilter (41) nach einem der vorangehenden Ansprüche, des Weiteren umfassend eine Detektionsschaltung (42) zum Detektieren von Fehlübereinstimmungen im Hochfrequenz-Verstärkungsparameter und in einem Niederfrequenz-Verstärkungsparameter (HFgain, LFgain) aus dem kompensierten Signal und zum Erzeugen eines entsprechenden Fehlübereinstimmungsdetektionssignals.

5. Entzerrerfilter (41) nach Anspruch 4, wobei das Fehlübereinstimmungsdetektionssignal sofort eine notwendige Erhöhung oder Senkung der Verstärkungsparameter (HFgain, LFgain) anzeigt.

6. Entzerrerfilter (41) nach einem der Ansprüche 4 oder 5, wobei der Schalter (34, 35; 38; 39) dazu ausgebildet ist, durch das Fehlübereinstimmungsdetektionssignal zu signalisieren, wodurch der Hochfrequenz-Verstärkungsparameter (HFgain) mit der notwendigen Erhöhung oder Senkung aktualisiert wird.

7. Entzerrerfilter (41) nach einem der Ansprüche 4 bis 6, wobei die Detektionsschaltung (42) eine Gleichrichterkomparatorschaltung ist.

8. Entzerrerfilter (41) nach einem der Ansprüche 4 bis 7, wobei die Detektionsschaltung (42) zwei Differenzeingänge (preA, preB, postA, postB) umfasst.

9. Entzerrerfilter (41) nach Anspruch 8, wobei jeder Differenzeingang zwei Eingangsknoten umfasst, wobei die Detektionsschaltung (42) dazu ausgebildet ist, aus jedem Differenzeingang Signale an jenen Eingangsknoten zu vergleichen, die die höchste Spannung aufweisen.

10. Entzerrerfilter (41) nach einem der Ansprüche 4 bis 9, wobei die Detektionsschaltung (42) einen Komparator (32) umfasst.

11. Entzerrerfilter (41) nach einem der Ansprüche 4 bis 10, wobei die Detektionsschaltung (42) dazu ausgebildet ist, Eingangs- und Ausgangssignale eines Begrenzungsverstärkers (47) zu vergleichen.

12. Entzerrerfilter (41) nach einem der Ansprüche 4 bis 11, wobei die Detektionsschaltung (42) des Weiteren mindestens einen Gleichrichter (30, 31) umfasst.

13. Entzerrerfilter (41) nach einem der Ansprüche 4 bis 12, wobei der Schalter zum zeitgerechten Ändern des Hochfrequenz-Verstärkungsparameters (HFgain) abhängig vom kompensierten Signal am Eingangsknoten der mindestens einen Kompensationsstufe dient.

14. Entzerrersystem zum Kompensieren eines empfangenen verzerrten Datensignals für frequenzabhängige Signalmodifizierungen, die durch einen Übertragungskanal eingeführt werden, wobei das Entzerrersystem ein Entzerrerfilter (41) nach einem der Ansprüche 1 bis 13 umfasst.

## Revendications

1. Filtre égaliseur (41) pour compenser un signal de données déformé reçu en ce qui concerne des modifications de signal dépendantes de la fréquence introduites par un canal de transmission, ledit filtre égaliseur (41) comprenant au moins un étage de compensation (43, 44, 45, 46), un étage de compensation (Xstage1, Xstage2, Xstage3, Xstage4) ayant deux ou plusieurs entrées de paramètres de gain (HFgain, LFgain), le filtre égaliseur (41) comprenant un ou plusieurs commutateurs (39), chacun servant à relier un signal de rétroaction de gain (adjust_gain) pour changer une entrée différente des entrées de paramètre de gain (HFgain) dans le temps en fonction du signal compensé, le filtre égaliseur étant **caractérisé en ce qu'**il comprend en outre un circuit de commande de connexion (33) pour sortir un signal (connect HF) pour commander chacun des commutateurs pour relier le signal de rétroaction de gain pour une partie différente d'un intervalle de temps entre des passages par zéro du signal compensé, et ayant moins de commutateurs que de paramètres de gain, ainsi le signal de rétroaction de gain (adjust_gain) est relié sans commutateur pour mettre à jour au moins un (LFgain) des paramètres de gain.

2. Filtre égaliseur (41) selon la revendication 1, le circuit de commande (33) pour commander la mise en action du commutateur de façon à commander quand un paramètre de gain de fréquence élevée (HFgain) est changé.

3. Filtre égaliseur (41) selon l'une quelconque des revendications précédentes, comprenant en outre un moyen de stockage pour stocker les paramètres de gain de fréquence élevée et de fréquence basse (HFgain, LFgain).

4. Filtre égaliseur (41) selon l'une quelconque des revendications précédentes, comprenant en outre un circuit de détection (42) pour détecter à partir du signal compensé des discordances dans le paramètre de gain de fréquence élevée et dans un paramètre de gain de fréquence basse (HFgain, LFgain), et pour produire un signal de détection de discordance correspondant.

5. Filtre égaliseur (41) selon la revendication 4, dans lequel le signal de détection de discordance indique instantanément une augmentation ou une diminution nécessaire des paramètres de gain (HFgain, LFgain).

6. Filtre égaliseur (41) selon l'une quelconque des revendications précédentes 4 ou 5, dans lequel le commutateur (34, 35 ; 38 ; 39) est conçu pour signaler par l'intermédiaire du signal de détection de discordance, mettant ainsi à jour le paramètre de gain de fréquence élevée (HFgain) avec l'augmentation ou la diminution nécessaire.

7. Filtre égaliseur (41) selon l'une quelconque des revendications 4 à 6, dans lequel le circuit de détection (42) est un circuit de comparateur redresseur.

8. Filtre égaliseur (41) selon l'une quelconque des revendications 4 à 7, dans lequel le circuit de détection (42) comprend deux entrées différentielles (*preA, preB ; postA, postB*).

9. Filtre égaliseur (41) selon la revendication 8, chaque entrée différentielle comprenant deux noeuds d'entrée, dans lequel le circuit de détection (42) est conçu pour comparer, à partir de chaque entrée différentielle, des signaux sur les noeuds d'entrée qui sont les plus élevés en ce qui concerne la tension.

10. Filtre égaliseur (41) selon l'une quelconque des revendications 4 à 9, dans lequel le circuit de détection (42) comprend un comparateur (32).

11. Filtre égaliseur (41) selon l'une quelconque des revendications 4 à 10, dans lequel le circuit de détection (42) est conçu pour comparer des signaux d'entrée et de sortie d'un amplificateur de limitation (47).

12. Filtre égaliseur (41) selon l'une quelconque des revendications 4 à 11, dans lequel le circuit de détection (42) comprend en outre au moins un redresseur (30, 31).

13. Filtre égaliseur (41) selon l'une quelconque des revendications 4 à 12, le commutateur servant à changer le paramètre de gain de fréquence élevée (HFgain) dans le temps en fonction du signal compensé au niveau de noeuds de sortie de l'au moins un étage de compensation.

14. Système égaliseur pour compenser un signal déformé reçu en ce qui concerne des modifications de signal dépendantes de la fréquence introduites par un canal de transmission, ledit système égaliseur comprenant un filtre égaliseur (41) selon l'une quelconque des revendications 1 à 13.
